# EUROPEAN PATENT APPLICATION

(11) **EP 4 053 886 A1**
(43) Date of publication of application: **07.09.2022**
(21) Application number: 21160023.4
(22) Date of filing: 01.03.2021
(51) Int. Cl.: H01L 21/48, H01L 23/498

(54) **METHOD FOR FABRICATING A SUBSTRATE WITH A SOLDER STOP STRUCTURE, SUBSTRATE WITH A SOLDER STOP STRUCTURE AND ELECTRONIC DEVICE**

(71) Applicant: Infineon Technologies AG, 85579 Neubiberg (DE)
(72) Inventor: WEDI, Andre, 59494 Soest (DE); BUEHNER, Tobias, 59581 Warstein (DE); CILIOX, Alexander, 59519 Moehnesee (DE); LAHL, Peter, 59558 Lippstadt (DE)
(74) Representative: Lambsdorff & Lange Patentanwälte Partnerschaft mbB

(57) **Abstract**

A method for fabricating a substrate comprising a solder stop structure comprises providing a substrate configured to carry a surface mounted device, the substrate comprising a ceramic layer and a metallization arranged on the ceramic layer, wherein the metallization comprises a base metal layer and a noble metal layer covering the base metal layer, and generating an oxidation structure on the metallization, wherein the oxidation structure divides the metallization into a first part and a second part, and wherein the oxidation structure is configured to act as a solder stop, wherein generating the oxidation structure comprises partially removing the noble metal layer.

## Description

### TECHNICAL FIELD

This disclosure relates in general to a method for fabricating a substrate comprising a solder stop structure, to a substrate comprising such a solder stop structure, and to an electronic device comprising such a substrate.

### BACKGROUND

Fabrication of electronic devices, for example semiconductor modules or semiconductor packages, may comprise an act of coupling several individual components like surface mounted devices and semiconductor dies to a substrate. Different coupling techniques may be used for different components, for example soldering for one component and welding, e.g. ultrasonic welding, for another component. In the case that soldering is used, bleed out of liquid solder material may occur and solder material may wet an area on the substrate that is intended as welding spot for another component. However, welding to a spot that is wetted by solder material is less reliable than welding to clean spots and therefore reliability issues may arise.

Commonly, a solder mask may be used to prevent liquid solder material from bleeding out of the intended soldering spot. However, solder masks exhibit certain disadvantages in the case that they are used on particular substrate, for example substrates with a nickel gold plated surface. For example, during soldering the gold layer may become liquid and may "crawl" under the solder mask. Furthermore, in the case that sintering is used in addition to soldering (in particular prior to soldering) in order to couple the components to the substrate, the solder mask may be partially torn off due to the sintering process and may therefore not cover the substrate as intended during the soldering process. Improved methods for fabricating substrates, improved substrates as well as improved electronic devices may help with solving these and other problems.

The problem on which the invention is based is solved by the features of the independent claims. Further advantageous examples are described in the dependent claims.

### SUMMARY

Various aspects pertain to a method for fabricating a substrate comprising a solder stop structure, the method comprising: providing a substrate configured to carry a surface mounted device, the substrate comprising a ceramic layer and a metallization arranged on the ceramic layer, wherein the metallization comprises a base metal layer and a noble metal layer covering the base metal layer, and generating an oxidation structure on the metallization, wherein the oxidation structure divides the metallization into a first part and a second part, and wherein the oxidation structure is configured to act as a solder stop, wherein generating the oxidation structure comprises partially removing the noble metal layer.

Various aspects pertain to a substrate with a solder stop structure, the substrate comprising: a ceramic layer, a metallization arranged on the ceramic layer, the metallization comprising a base metal layer and a noble metal layer covering the base metal layer, and an oxidation structure arranged on the metallization, wherein the oxidation structure divides the metallization into a first part and a second part and wherein the oxidation structure is configured to act as a solder stop, wherein the substrate is configured to carry a surface mounted device, and wherein the noble metal layer is removed in the oxidation structure.

### BRIEF DESCRIPTION OF THE DRAWINGS

The accompanying drawings illustrate examples and together with the description serve to explain principles of the disclosure. Other examples and many of the intended advantages of the disclosure will be readily appreciated in view of the following detailed description. The elements of the drawings are not necessarily to scale relative to each other. Identical reference numerals designate corresponding similar parts.
Figure 1 shows a sectional view of a substrate comprising an oxidation structure, wherein the oxidation structure is configured to act as a solder stop structure.
Figure 2 shows a top view of a further substrate comprising an oxidation structure, in particular an oxidation structure with a "closed" shape.
Figure 3 shows a detail view of a further substrate with oxidation structures in a top view perspective.
Figures 4A and 4B show detail views of electronic devices comprising substrates with oxidation structures in a top view perspective.
Figure 5 shows a detail view of a further electronic device comprising a substrate with an oxidation structure, an SMD and a semiconductor die in a top view perspective.
Figure 6 is a flow chart of a method for fabricating a substrate with an oxidation structure.
Figure 7 is a flow chart of a method for fabricating an electronic device.

### DETAILED DESCRIPTION

In the following detailed description directional terminology, such as "top", "bottom", "left", "right", "upper", "lower" etc., is used with reference to the orientation of the Figure(s) being described. Because components of the disclosure can be positioned in a number of different orientations, the directional terminology is used for purposes of illustration only. It is to be understood that other examples may be utilized and structural or logical changes may be made.

In addition, while a particular feature or aspect of an example may be disclosed with respect to only one of several implementations, such feature or aspect may be combined with one or more other features or aspects of the other implementations as may be desired and advantageous for any given or particular application, unless specifically noted otherwise or unless technically restricted. Furthermore, to the extent that the terms "include", "have", "with" or other variants thereof are used in either the detailed description or the claims, such terms are intended to be inclusive in a manner similar to the term "comprise". The terms "coupled" and "connected", along with derivatives thereof may be used. It should be understood that these terms may be used to indicate that two elements cooperate or interact with each other regardless whether they are in direct physical or electrical contact, or they are not in direct contact with each other; intervening elements or layers may be provided between the "bonded", "attached", or "connected" elements. However, it is also possible that the "bonded", "attached", or "connected" elements are in direct contact with each other. Also, the term "exemplary" is merely meant as an example, rather than the best or optimal.

The electronic devices described below may include one or more semiconductor chips. By way of example, one or more semiconductor power chips may be included. Further, one or more logic integrated circuits may be included in the devices. The logic integrated circuits may be configured to control the integrated circuits of other semiconductor chips, for example the integrated circuits of power semiconductor chips.

An efficient electronic device may for example reduce material consumption, ohmic losses and/or chemical waste and thus enable energy and/or resource savings. Improved methods of fabrication as well as improved substrates and improved electronic devices, as specified in this description, may thus at least indirectly contribute to green technology solutions, i.e. climate-friendly solutions providing a mitigation of energy and/or resource use.

The notation XY may refer to an alloy or to a solder material composition of X including at least Y as a further component. In particular, it may refer to an alloy or a solder material composition of X including Y as a sole residual component (i.e. a closed composition). That is, in the second case, the notation XY means that the alloy XY or the solder material composition XY has a composition consisting of X (of the percentage in weight of X) and Y (of the percentage in weight of Y), the balance being only inevitable elements. The notation XYZ... has an analogous meaning, i.e. an "open composition" or a "closed composition" with X, Y, Z, ... forming the sole constituents of the alloy (except inevitable elements).

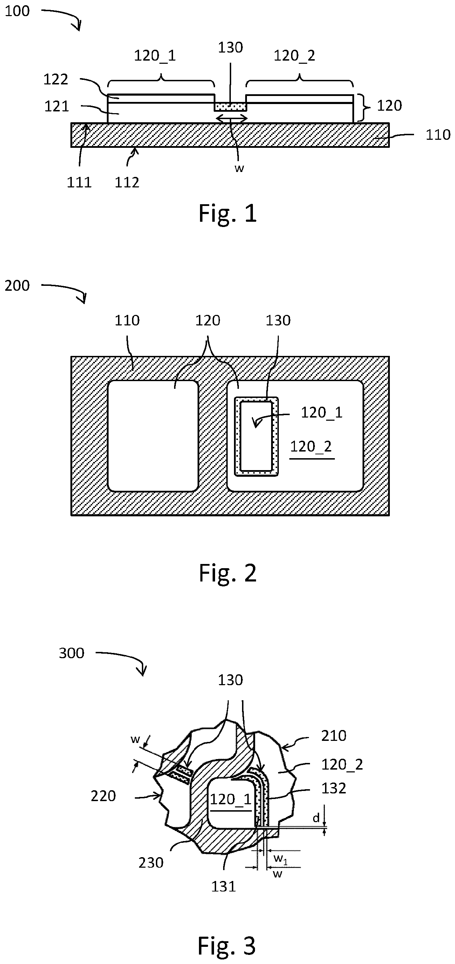

Figure 1 shows a sectional view of a substrate 100 comprising a ceramic layer 110, a metallization 120 arranged on the ceramic layer 110 and an oxidation structure 130 arranged on the metallization 120. The metallization 120 comprises a base metal layer 121 and a noble metal layer 122 at least partially covering the base metal layer 121. The oxidation structure 130 divides the metallization 120 into a first part 120_1 and a second part 120_2. Furthermore, the oxidation structure 130 is configured to act as a solder stop.

The substrate 100 is configured to carry a surface mounted device (not shown in Fig. 1). The surface mounted device (SMD) may e.g. be a capacitor, a resistor (in particular an NTC - negative thermal coefficient), an inductor, a diode, etc. The substrate 100 may further be configured to carry a semiconductor die which may e.g. be arranged laterally next to the SMD. The semiconductor die may e.g. comprise an integrated circuit or a power circuit. The substrate 100 may for example be or comprise a nickel gold plated ceramic substrate. The substrate 100 may for example be of the type direct copper bond (DCB), direct aluminum bond (DAB), active metal brazing (AMB) or any other suitable type of substrate. The substrate 100 may be configured for use in a semiconductor module or a semiconductor package, in particular a module or a package comprising a plastic frame or a molded body which at least partially encapsulates the substrate 100.

The ceramic layer 110 may comprise any suitable type of ceramic, e.g. an oxide ceramic, a nitride ceramic, etc. The ceramic layer 110 may have a first side 111 and an opposing second side 112. The metallization 120 may be arranged on the first side 111 as shown in the example of Fig. 1. However, according to another example, it is also possible that the substrate 100 further comprises a second metallization arranged on the second side 112. The second metallization may be structurally similar or identical to the metallization 120. Furthermore, a second oxidation structure may be arranged on the second metallization.

The metallization 120 may be a structured layer comprising contact pads and/or conducting paths electrically insulated from each other by trenches. The metallization 120 may solely consist of the base metal layer 121 and the noble metal layer 122 or it may comprise one or more further metal layers which may be arranged above, in between or below the metal layers 121, 122.

The base metal layer 121 may for example have a thickness measured perpendicular to the first side 111 in the range of 1µm to 10µm, in particular in the range of 3µm to 5µm. The noble metal layer 122 may for example have a thickness in the range of 20nm to 200nm, in particular in the range of 50nm to 100nm.

According to an example, a further metal layer comprising or consisting of copper or a copper alloy is arranged between the base metal layer 121 and the ceramic layer 110. This copper layer may for example have a thickness in the range of 100µm to 500µm, e.g. about 300µm. According to another example, the base metal layer 121 is arranged directly on the first side 111 of the ceramic layer and the noble metal layer 122 is arranged directly on the base metal layer 121.

According to an example, the base metal layer 121 comprises nickel or a nickel alloy or copper or a copper alloy. The noble metal layer 122 may for example comprise silver or gold or any other suitable noble metal. The noble metal layer 122 may for example be configured as a cap layer for preventing oxidation of the base metal layer 121 and/or as a contact layer configured for providing a suitable surface for soldering and/or sintering.

The noble metal layer 122 is removed in the oxidation structure 130. This may in particular mean that the oxidation structure 130 is not covered by the noble metal layer 122. According to an example, a laser is used to fabricate the oxidation structure 130. This may comprise removing the noble metal layer 122 with the laser in a predefined region of the metallization 120, thereby allowing the revealed part of the base metal layer 121 to oxidize (e.g. by reacting with an oxidizing atmosphere).

The oxidation structure 130 may comprise or consist of an oxide of the metal of the base metal layer 121, e.g. nickel oxide. The oxidation structure 130 may be located in or on top of the base metal layer 121, in particular at an upper surface of the base metal layer 121 pointing away from the ceramic layer 110.

The oxidation structure 130 may for example have a width w of 100µm or more, or 150µm or more, or 200µm or more, or 300µm or more, or 400µm or more. The oxidation structure 130 may have any suitable thickness, e.g. a thickness of 5nm or more, 10nm or more, 20nm or more, 50nm or more, 100nm or more, or 500nm or more.

According to an example, the oxidation structure 130 comprises a "natural" oxide, meaning an oxide that is formed by exposing the base metal layer 121 to the environment. According to another example, the oxidation structure 130 comprises a deposited oxide. The oxidation structure 130 may comprise one or more precision-lasered lanes or stripes arranged laterally next to each other (this is described in greater detail with regard to Fig. 3).

The oxidation structure 130 may be configured to act as a solder stop structure, meaning that liquid solder material does not traverse the oxidation structure 130 from the first part 120_1 to the second part 120_2 or vice versa.

As noted above, the substrate 100 may be configured to carry an SMD and/or a semiconductor die. For example, a sintering process may be used to attach the semiconductor die to the substrate 100 and a welding process (e.g. ultrasonic welding) or a soldering process may be used to electrically couple contacts of the semiconductor die to the substrate 100. A soldering process may also be used to attach and electrically couple the SMD to the substrate 100. However, during a soldering process liquid solder material may bleed out of the intended contact spot. This may go so far that spots on the substrate 100 that are intended for other contacts are also wetted by the solder material. Since welding on solder wetted surfaces may negatively impact the reliability of the connection formed, it may be desired to prevent or contain such bleed outs.

The oxidation structure 130 may act as a solder stop structure because the wettability of an oxide is much smaller than the wettability of the noble metal layer 122 or the base metal layer 121. Liquid solder material may therefore be prevented from bleeding out over the oxidation structure 130. Therefore, by placing the oxidation structure 130 between two contact spots on the substrate 100, the above-mentioned problems due to solder bleed out may be prevented.

It should be noted that the oxidation structure 130 may be arranged on a contiguous part of the metallization 120 (e.g. a first connection area), meaning that the first part 120_1 and the second part 120_2 are still electrically coupled to each other, e.g. by the base metal layer 121, although the oxidation structure 130 is arranged in between and although the noble metal layer 122 is absent above the oxidation structure 130.

Figure 2 shows a top view of a further substrate 200 which may be similar to or identical with the substrate 100. In the example shown in Fig. 2 the oxidation structure 130 has the shape of a closed loop.

As shown in Fig. 2, the oxidation structure 130 completely surrounds the first part 120_1 on all sides. However, according to another example, the substrate 200 may comprise small gaps in the oxidation structure 130. These one or more gaps may be small enough or thin enough that liquid solder material is prevented from bleeding out of the first part 120_1 via the gaps by its own surface tension.

The oxidation structure 130 may have any suitable shape, for example a circular shape, a rectangular shape, a quadratic shape, an irregular shape, etc. As shown in Fig. 2, the oxidation structure 130 may have a shape with rounded corners which may be due to the fabrication process. It is however also be possible that a rounded shape has an increased ability of trapping liquid solder material compared to a shape with sharp corners.

The metallization 120 of the substrate 200 comprises a first connection area 210 and a second connection area 220. The two connection areas 210, 220 are electrically and physically separated from each other by a trench 230 located between the connection areas 210, 220. The first and second parts 120_1, 120_2 and the oxidation structure 130 are located on the first connection area 210. The first connection area 210, in particular the first part 120_1, may be configured as a contact pad for a first contact of an SMD and the second connection area 220 may be configured as a contact pad for a second contact of the SMD. Additionally, the first connection area 210, in particular the second part 120_2, may be configured as a contact pad for a contact of a semiconductor die.

The first part 120_1 may comprise any suitable fraction of the surface area of the first connection area 210, e.g. 30% or less, 50% or less, or 70% or less.

According to an example, the first part 120_1 is configured for soldering and the second part 120_2 is configured for (ultrasonic) welding. In other words, the oxidation structure 130 is configured to keep liquid solder material inside the first part 120_1. According to another example, the first part 120_1 is configured for (ultrasonic) welding and the second part 120_2 is configured for soldering. In other words, in this case the oxidation structure 130 surrounding the first part 120_1 is configured to keep liquid solder material out of the first part 120_1.

Figure 3 shows a detail view of a further substrate 300 in a top view perspective. The substrate 300 may be similar to or identical with the substrate 300, except for the differences described in the following.

In the example shown in Fig. 3, the substrate 300 comprises oxidation structures 130 on both the first and second connection areas 210, 220. However, it is of course also possible that only one of the connection areas 210, 220 comprises an oxidation structure 130.

In the substrate 300 the oxidation structure 130 does not surround the first part 120_1 completely. Instead, the oxidation structure 130 essentially extends from one edge of the respective connection area 210, 220 to another edge, thereby separating the respective connection area 210, 220 into the first and second parts 120_1, 120_2.

The shape of the oxidation structure 130 shown in Fig. 3 may be termed an "open" shape because it comprises a first end and a second end which do not meet, whereas the shape shown in Fig. 2 may be termed a "closed" shape because the oxidation structure 130 in Fig. 2 forms a closed loop around the first part 120_1.

As shown in Fig. 3, the oxidation structure 130 does not necessarily have to extend to the respective edge of the connection areas 210, 220 completely. Instead, the oxidation structure 130 may be arranged at a minimum distance d from the edges. The minimum distance d may for example be in the range of 20µm to 300µm, in particular in the range of 50µm to 150µm, more in particular about 70µm or about 100µm. The minimum distance d may be small enough that no liquid solder material can bleed out along the remaining ridge between the oxidation structure 130 and the edge of the connection area 210, 220.

By placing the oxidation structure 130 at the minimum distance d from the edges of the connection areas 210, 220, accidental damage to the vertical lateral sides of the connection areas 210, 220 and/or to the ceramic layer 110 in the trench 230 by the laser used to fabricate the oxidation structure 130 may be prevented. Such kind of damage may for example cause delamination issues and/or electrical shorts.

As shown in Fig. 3, the oxidation structure 130 may comprise several lanes or stripes arranged laterally next to each other. The oxidation structure 130 may for example comprise a first stripe 131 and a second stripe 132. The oxidation structure 130 may also comprise a third stripe, a fourth stripe and so on or it may comprise only a single stripe. The stripes 131, 132 may for example be spaced apart at a spacing in the range of 50µm to 400µm, in particular in the range of 100µm to 300µm, more in particular about 200µm. An overall width w of the oxidation structure 130 may be in the range disclosed further above with respect to Fig. 1. Each stripe 131, 132 may for example have a width w₁ of about 100µm.

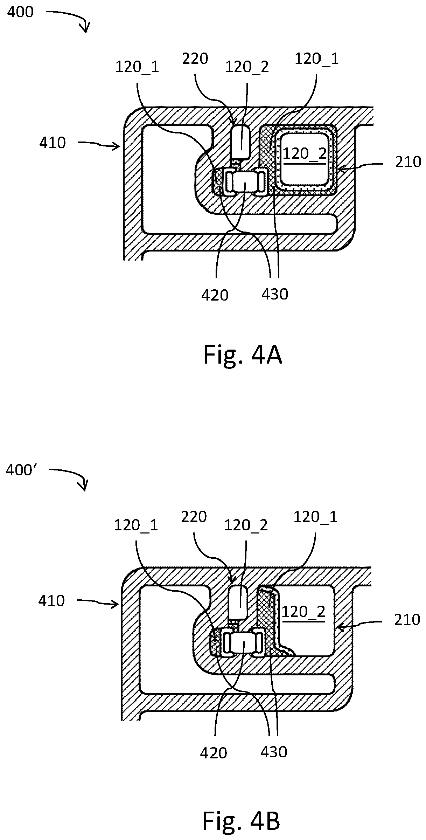

Figures 4A and 4B show detailed views of electronic devices 400 and 400' comprising a substrate 410 and an SMD 420 arranged on and electrically coupled to the substrate 410. The substrate 410 may be similar to or identical with anyone of the substrates 100, 200 and 300.

The SMD 420 may for example comprise a resistor, a capacitor, an inductor or a diode. The SMD 420 may be arranged on the substrate 410 such that a first contact of the SMD 420 is coupled to the first connection area 210 and a second contact of the SMD 420 is coupled to the second connection area 220. Solder joints may be used to couple the contacts of the SMD to the first and second connection areas 210, 220. Solder material 430 may bleed out of the solder joints and may wet the first parts 120_1 of the connection areas 210, 220. The first contact of the SMD 420 may in particular be coupled to the first part 120_1 of the first connection area 210 and the second contact of the SMD 420 may in particular be coupled to the first part 120_1 of the second connection area 220.

In electronic device 400 shown in Fig. 4A the oxidation structure 130 on the first connection area 210 has a closed shape surrounding the second part 120_2 and in electronic device 400' shown in Fig. 4B the oxidation structure 130 on the first connection area 210 has an open shape.

The second part 120_2 on the first connection area 210 and/or the second part 120_2 on the second connection area 220 may be configured for having a contact of a semiconductor die or any other contact, e.g. an external contact of the electronic device 400, 440', welded to it and thereby electrically connecting this contact with the SMD.

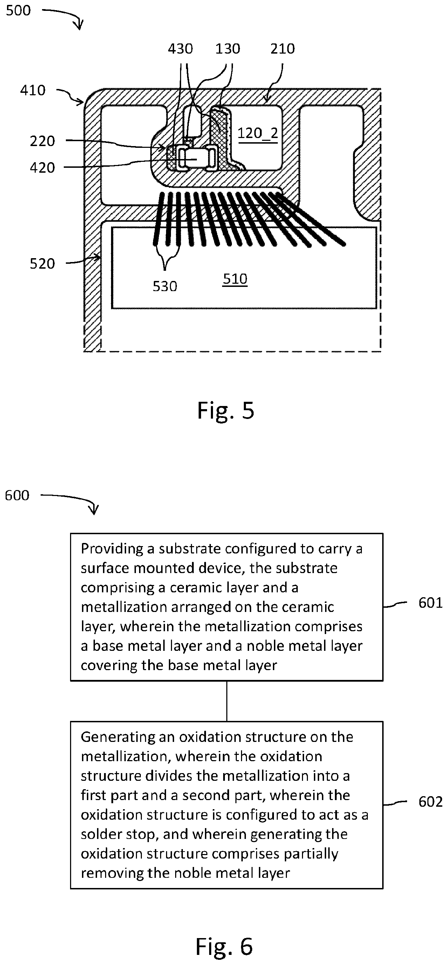

Figure 5 shows a detail view of an electronic device 500 in a top view perspective. The electronic device 500 may be similar to or identical with the electronic devices 400 and 400'.

As shown in Fig. 5 the electronic device 500 comprises a semiconductor die 510 in addition to the components already described with respect to the electronic devices 400 and 400'. The semiconductor die 510 may for example be arranged on a third connection area 520, different from the first and second connection areas 210, 220 of the metallization 120.

According to an example, the semiconductor die 510 is sintered to the third connection area 520. A sintered joint may provide a low resistance thermal coupling between the semiconductor die 510 and the substrate 410. The semiconductor die 510 may be electrically coupled to the substrate 410 by bond wires 530. Instead of bond wires, ribbons or contact clips may be used as well.

The SMD 420 is coupled to the substrate 410 by solder joints and solder material 430 may bleed out of the solder joints. The bleed out of the solder material 430 is stopped by the oxidation structures 130 and the solder material 430 therefore does not extend onto second parts 120_2 on the connection areas 210, 220.

A wettability of the metallization 120 (in particular the noble metal layer 122) may depend on the particular solder material used. Furthermore, the ability of the oxidation structure 130 to act as a solder stop structure as explained above may also depend on the solder material used. The oxidation structure 130 may work especially well with SnSb solder material, in particular with SnSb solder material having a Sb amount in the range of 1wt% to 10wt%, for example about 5wt%. The oxidation structure 130 may in particular work better in combination with a SnSb solder material than in combination with a SnAg solder material. Liquid SnAg solder material may be able to traverse the oxidation structure 130 and may wet the second parts 120_2.

For this reason, it may be beneficial to use SnSb solder material (in particular instead of SnAg solder material) in electronic devices comprising the oxidation structure 130, like the electronic devices 400, 400' and 500.

Figure 6 is a flow chart of a method 600 for fabricating a substrate comprising a solder stop structure. The method 600 may for example be used to fabrication the substrates 100, 200 and 300.

Method 600 comprises at 601 an act of providing a substrate configured to carry a surface mounted device, the substrate comprising a ceramic layer and a metallization arranged on the ceramic layer, wherein the metallization comprises a base metal layer and a noble metal layer covering the base metal layer. Method 600 comprises at 602 an act of generating an oxidation structure on the metallization, wherein the oxidation structure divides the metallization into a first part and a second part, wherein the oxidation structure is configured to act as a solder stop, and wherein generating the oxidation structure comprises partially removing the noble metal layer.

According to an example of method 600, generating the oxidation structure comprises partially removing the noble metal layer using a laser and thereby partially exposing the base metal layer and letting it oxidize. An oxidizing atmosphere may be used to hasten oxidation of the base metal.

Any suitable laser may be used to partially remove the noble metal layer, for example a laser setup used for labeling a substrate or an electronic device. According to an example, the standard power output settings of such a labeling laser may be used. According to an example, the oxidation structure(s) may be generated while the substrate is still part of a larger compound of substrates (i.e. prior to singulating the substrate).

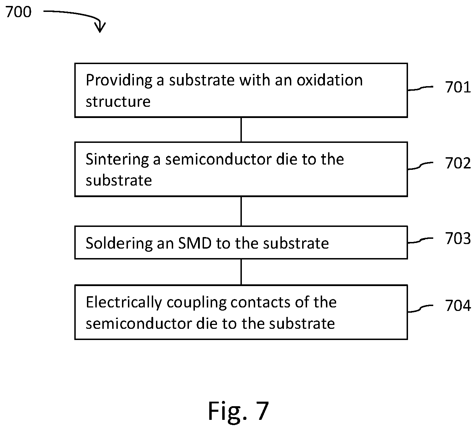

Figure 7 is a flow chart of a method 700 for fabricating an electronic device. The method 700 may for example be used for fabricating the electronic devices 400, 400' and 500.

Method 700 comprises at 701 an act of providing a substrate which comprises an oxidation structure (for example the substrate 410), at 702 an act of sintering a semiconductor die to the substrate, at 703 an act of soldering an SMD to the substrate, and at 704 an act of electrically coupling contacts of the semiconductor die to the substrate. The act of coupling 704 may comprise welding bond wires or ribbons or contact clips to a part of a metallization of the substrate that is protect from solder bleed out by the oxidation structure.

### EXAMPLES

In the following, a method for fabricating a substrate comprising a solder stop structure, a substrate with a solder stop structure, and an electronic device are further explained using specific examples.
Example 1 is a method for fabricating a substrate comprising a solder stop structure, the method comprising: providing a substrate configured to carry a surface mounted device, the substrate comprising a ceramic layer and a metallization arranged on the ceramic layer, wherein the metallization comprises a base metal layer and a noble metal layer covering the base metal layer, and generating an oxidation structure on the metallization, wherein the oxidation structure divides the metallization into a first part and a second part, and wherein the oxidation structure is configured to act as a solder stop, wherein generating the oxidation structure comprises partially removing the noble metal layer.
Example 2 is the method of example 1, wherein the noble metal layer is partially removed using a laser.
Example 3 is the method of example 1 or 2, wherein the noble metal layer comprises gold or silver.
Example 4 is the method of one of the preceding examples, wherein the base metal layer comprises nickel or a nickel alloy or copper or a copper alloy.
Example 5 is the method of one of the preceding examples, wherein the oxidation structure comprises an oxide of the material of the base metal layer.
Example 6 is a substrate with a solder stop structure, the substrate comprising: a ceramic layer, a metallization arranged on the ceramic layer, the metallization comprising a base metal layer and a noble metal layer covering the base metal layer, and an oxidation structure arranged on the metallization, wherein the oxidation structure divides the metallization into a first part and a second part and wherein the oxidation structure is configured to act as a solder stop, wherein the substrate is configured to carry a surface mounted device, and wherein the noble metal layer is removed in the oxidation structure.
Example 7 is the substrate of example 6, wherein the metallization comprises a first connection area and a second connection area electrically insulated from each other by a trench, and wherein the oxidation structure, the first part and the second part are arranged on the first connection area.
Example 8 is the substrate of example 6 or 7, wherein a minimum distance of the oxidation structure from the trench is 70µm or more.
Example 9 is the substrate of one of examples 6 to 8, wherein a minimum width of the oxidation structure separating the first part from the second part is 100µm or more.
Example 10 is the substrate of one of examples 6 to 9, wherein the noble metal layer comprises gold or silver, wherein the base metal layer comprises nickel or a nickel alloy or copper or a copper alloy, and wherein the oxidation structure comprises an oxide of the material of the base metal layer.
Example 11 is the substrate of one of examples 6 to 10, wherein the oxidation structure completely surrounds the second part on all sides.
Example 12 is an electronic device, comprising: the substrate of one of examples 6 to 11, a solder joint, and a surface mounted device coupled to the substrate by the solder joint such that one contact of the surface mounted device is coupled to the metallization on the first part.
Example 13 is the electronic device of example 12, wherein the solder joint comprises a SnSb solder material.
Example 14 is the electronic device of example 12 or 13, wherein the surface mounted device comprises a resistor, a capacitor, an inductor, or a diode.
Example 15 is the electronic device of one of examples 12 to 14, further comprising: a semiconductor die sintered to the substrate, wherein the semiconductor die comprises at least one contact electrically coupled to the metallization by a further solder joint.
Example 16 is an apparatus comprising means for performing the method according to anyone of examples 1 to 6.
Example 17 is an apparatus comprising means for performing a method, wherein the method comprises an act of providing a substrate which comprises an oxidation structure, an act of sintering a semiconductor die to the substrate, an act of soldering an SMD to the substrate, and an act of electrically coupling contacts of the semiconductor die to the substrate. The act of coupling may comprise welding bond wires or ribbons or contact clips to a part of a metallization of the substrate that is protect from solder bleed out by the oxidation structure.

While the disclosure has been illustrated and described with respect to one or more implementations, alterations and/or modifications may be made to the illustrated examples without departing from the spirit and scope of the appended claims. In particular regard to the various functions performed by the above described components or structures (assemblies, devices, circuits, systems, etc.), the terms (including a reference to a "means") used to describe such components are intended to correspond, unless otherwise indicated, to any component or structure which performs the specified function of the described component (e.g., that is functionally equivalent), even though not structurally equivalent to the disclosed structure which performs the function in the herein illustrated exemplary implementations of the disclosure.

## Claims

1. A method for fabricating a substrate comprising a solder stop structure, the method comprising:
providing a substrate configured to carry a surface mounted device, the substrate comprising a ceramic layer and a metallization arranged on the ceramic layer, wherein the metallization comprises a base metal layer and a noble metal layer covering the base metal layer, and
generating an oxidation structure on the metallization, wherein the oxidation structure divides the metallization into a first part and a second part, and wherein the oxidation structure is configured to act as a solder stop,
wherein generating the oxidation structure comprises partially removing the noble metal layer.

2. The method of claim 1, wherein the noble metal layer is partially removed using a laser.

3. The method of claim 1 or 2, wherein the noble metal layer comprises gold or silver.

4. The method of one of the preceding claims, wherein the base metal layer comprises nickel or a nickel alloy or copper or a copper alloy.

5. The method of one of the preceding claims, wherein the oxidation structure comprises an oxide of the material of the base metal layer.

6. A substrate with a solder stop structure, the substrate comprising:
a ceramic layer,
a metallization arranged on the ceramic layer, the metallization comprising a base metal layer and a noble metal layer covering the base metal layer, and
an oxidation structure arranged on the metallization, wherein the oxidation structure divides the metallization into a first part and a second part and wherein the oxidation structure is configured to act as a solder stop,
wherein the substrate is configured to carry a surface mounted device, and
wherein the noble metal layer is removed in the oxidation structure.

7. The substrate of claim 6, wherein the metallization comprises a first connection area and a second connection area electrically insulated from each other by a trench, and
wherein the oxidation structure, the first part and the second part are arranged on the first connection area.

8. The substrate of claim 6 or 7, wherein a minimum distance of the oxidation structure from the trench is 70µm or more.

9. The substrate of one of claims 6 to 8, wherein a minimum width of the oxidation structure separating the first part from the second part is 100µm or more.

10. The substrate of one of claims 6 to 9, wherein the noble metal layer comprises gold or silver, wherein the base metal layer comprises nickel or a nickel alloy or copper or a copper alloy, and wherein the oxidation structure comprises an oxide of the material of the base metal layer.

11. The substrate of one of claims 6 to 10, wherein the oxidation structure completely surrounds the second part on all sides.

12. An electronic device, comprising:
the substrate of one of claims 6 to 11,
a solder joint, and
a surface mounted device coupled to the substrate by the solder joint such that one contact of the surface mounted device is coupled to the metallization on the first part.

13. The electronic device of claim 12, wherein the solder joint comprises a SnSb solder material.

14. The electronic device of claim 12 or 13, wherein the surface mounted device comprises a resistor, a capacitor, an inductor, or a diode.

15. The electronic device of one of claims 12 to 14, further comprising:
a semiconductor die sintered to the substrate,
wherein the semiconductor die comprises at least one contact electrically coupled to the metallization by a further solder joint.
